# EUROPÄISCHE PATENTANMELDUNG

(11) **EP 0 870 642 A2**
(43) Veröffentlichungstag der Anmeldung: **14.10.1998**
(21) Anmeldenummer: 98106225.0
(22) Anmeldetag: 06.04.1998
(51) Int. Cl.: B60Q 1/02, H05K 3/32

(54) **Träger zum mechanischen Halten und elektrischen Verbinden elektronischer Bauelemente, insbesondere von Leuchtdioden, sowie Verfahren zum elektrisch leitenden Verbinden der Bauelemente auf einem Träger**

(30) Priorität: 11.04.1997 DE 19715093
(71) Anmelder: Hermann Stahl GmbH, 71723 Grossbottwar (DE)
(72) Erfinder: Stahl, Hermann, 71711 Steinheim/Murr (DE); Windt, Uwe, 71720 Oberstenfeld (DE)
(74) Vertreter: Wasmuth, Rolf, Dipl.-Ing.

(57) **Zusammenfassung**

Die Erfindung betrifft einen Träger zum mechanischen Halten und elektrischen Verbinden von Leuchtdioden. Der Träger (1) besteht aus einem elektrisch leitfähigen Blech (2, 3), auf dem die Anschlußfahnen (11) der Leuchtdioden (10) elektrisch leitend festgelegt sind. Zur Erzielung einer gut leitenden elektrischen Verbindung bei hoher mechanischer Stabilität ist vorgesehen, zumindest auf der Kontaktseite (17) des Trägers (1) noppenartige Haltezapfen (5) vorzusehen, die als Hohlnieten aus dem Blechmaterial des Trägers (1) ausgeprägt sind und eine Öffnung (12) in der Anschlußfahne (11) der Leuchtdioden (10) durchragen, wobei das mechanisch verformte Kopfende (7) des Haltezapfens (5) den Rand (13) der Öffnung (12) in der Anschlußfahne (11) übergreift.

## Beschreibung

Die Erfindung betrifft einen Träger zum mechanischen Halten und elektrischen Verbinden elektronischer Bauelemente, insbesondere von Leuchtdioden, nach dem Oberbegriff des Anspruchs 1 sowie ein Verfahren zum elektrisch leitenden Verbinden der Bauelemente auf einem Träger.

Im modernen Fahrzeugbau werden, insbesondere im Bereich der Rückleuchten, die bisher verwendeten Glühbirnen durch Leuchtdioden mit starker Leuchtkraft zu ersetzen. Leuchtdioden sind mechanisch stärker belastbar und haben eine längere Lebensdauer, so daß derartige Leuchten auch fest in der Fahrzeugkarosserie verbaut werden können, ohne aufwendige Zugangsöffnungen zum Austausch von Leuchtmitteln vorsehen zu müssen.

Es ist bekannt, Leuchtdioden auf einem elektrisch leitenden Träger mechanisch festzulegen. Hierzu sind die Leuchtdioden mit ihren Anschlußfahnen auf dem Träger zu positionieren und elektrisch leitend zu befestigen.

Der Erfindung liegt die Aufgabe zugrunde, einen Träger der gattungsgemäßen Art derart auszubilden, daß die elektronischen Bauelemente auf einfache Weise und mechanisch hoch belastbar sowie elektrisch gut leitend mit dem Träger zu verbinden sind.

Die Aufgabe wird erfindungsgemäß nach den kennzeichnenden Merkmalen des Anspruchs 1 gelöst.

Die noppenartigen Haltezapfen sind aus dem elektrisch leitenden Material des Trägers ausgeprägt und durchgreifen Öffnungen in den Anschlußfahnen, wodurch ein Formschluß mit hoher mechanischer Belastbarkeit gegeben ist. Das aus der Anschlußfahne herausragende Kopfende des Haltezapfens wird durch Quetschen mechanisch verformt, so daß das Kopfende des verquetschten Haltezapfens den Rand der Öffnung in der Anschlußfahne übergreift und eine hochbelastbare, formschlüssige Verbindung herstellt. Durch das Verquetschen wird gleichzeitig eine innige Anlage des Haltezapfens in der Öffnung der Anschlußfahne erzielt, wodurch eine gut elektrisch leitende Verbindung gegeben ist, die auch bei mechanischer Belastung unverändert aufrechterhalten bleibt.

Der erfindungsgemäß gestaltete Träger erhält nach dem Bestücken mit den elektronischen Bauelementen eine hohe Stabilität, wodurch zusätzliche Maßnahmen zwecks Kraftentlastung der Verbindung entbehrlich sind.

Bevorzugt ist der Kopfdurchmesser des freien Endes des Haltezapfens geringfügig kleiner als der Durchmesser der Öffnung in der Anschlußfahne und der Fußdurchmesser des Haltezapfens geringfügig größer als der Durchmesser der Öffnung in der Anschlußfahne. Dadurch wird erreicht, daß bei dem axialen Aufsetzen des Bauelementes die Anschlußfahnen auf den Haltezapfen festgeklemmt werden, so daß zusätzliche Sicherungsmittel zur Fixierung des Bauelementes beim Quetschvorgang des Haltezapfens entfallen können.

Die axiale Höhe des Haltezapfens ist um ein Mehrfaches länger, bevorzugt mindestens dreimal so lang wie die Dicke der Anschlußfahne. Auf diese Weise ist ein ausreichender Überstand des Haltezapfens und damit ausreichend Material zum Verquetschen gegeben.

Nach dem angegebenen Verfahren werden an den vorgesehenen Befestigungspunkten aus dem Träger Haltezapfen ausgeprägt, wonach die Bauelemente mit in den Anschlußfahnen vorgesehenen Öffnungen auf die Haltezapfen aufgesetzt werden. Die aus den Öffnungen hervorstehenden Köpfe der Haltezapfen werden dann nach Art eines Nietkopfes verformt, um den Rand der Öffnung in der Anschlußfahne zu übergreifen und die mechanische Fixierung auf dem Träger bei gleichzeitiger Herstellung einer elektrisch leitenden Verbindung zu erzielen.

Weitere Merkmale der Erfindung ergeben sich aus den weiteren Ansprüchen, der Beschreibung und der Zeichnung, in der nachfolgend ein Ausführungsbeispiel der Erfindung dargestellt ist. Es zeigen:
- Fig. 1: in schematischer Ansicht einen Teilschnitt durch einen Träger mit einer darauf zu befestigenden Anschlußfahne eines nicht näher dargestellten elektronischen Bauelementes,
- Fig. 2: einen Schnitt durch eine auf einem Träger elektrisch leitend befestigte Anschlußfahne eines Bauelementes,
- Fig. 3: in Draufsicht einen Träger mit darauf elektrisch leitend befestigten Leuchtdioden.

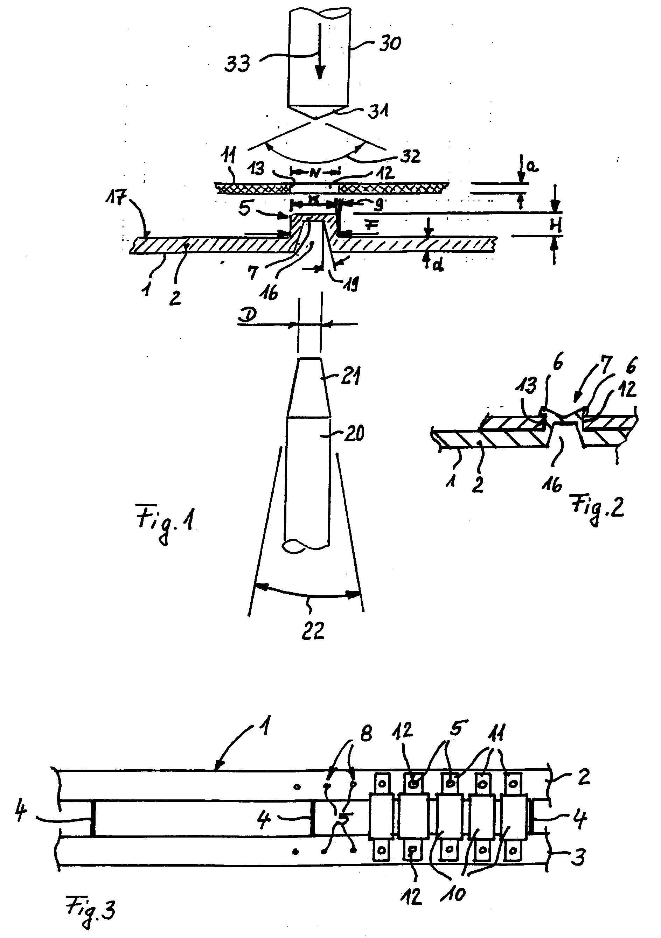

Leuchtzeichen wie Ampelanlagen, Warnleuchten und auch Rückleuchten von Kraftfahrzeugen werden vermehrt mit einer Vielzahl von Leuchtdioden bestückt, wobei zur Erzielung einer ausreichenden Leuchtkraft eine Vielzahl von Leuchtdioden anzuordnen sind. Wie in Fig. 3 gezeigt, sind die Leuchtdioden 10 auf einem Träger 1 angeordnet, der im Ausführungsbeispiel aus einem elektrisch leitenden Blech besteht. Dieses Blech kann aus zwei benachbart zueinander liegenden Blechstreifen 2 und 3 bestehen, die zur vorläufigen Fixierung mit Verbindungsstegen 4 untereinander verbunden sind. Die Leuchtdioden 10 werden mit ihren Anschlußfahnen 11 auf den Blechstreifen 2 und 3 mechanisch fest und elektrisch leitend befestigt. Hierzu weist der Träger 1 an ausgewählten Befestigungspunkten 8 Haltezapfen 5 auf, die entsprechende Öffnungen 12 in den Anschlußfahnen 11 der Leuchtdioden 10 durchgreifen. Wie Fig. 2 zeigt, werden die Köpfe 7 der Haltezapfen 5 verquetscht, wodurch die mechanisch feste, elektrisch leitende Verbindung der Anschlußfahnen 11 mit den Blechstreifen 2 und 3 gewährleistet ist. Nach dem Bestücken des Trägers 1 werden die Verbindungsstege 4 zwischen den Blechstreifen 2 und 3 entfernt, so daß durch Anlegen einer Versorgungsspannung zwischen den Blechstreifen 2 und 3 die Leuchtdioden 10 betrieben werden können.

In Fig. 1 ist das Prinzip der mechanischen, elektrisch leitenden Verbindung der Anschlußfahnen 11 mit dem Träger 1 dargestellt. An den vorgesehenen Befestigungspunkten 8 des Trägers 1 werden aus dem Material des elektrisch leitenden Bleches bzw. des Blechstreifens 2 auf der Kontaktseite 17 Haltezapfen 5 ausgeprägt, wozu ein Prägestempel 20 vorgesehen ist, dessen Prägekopf 21 konisch verjüngt zuläuft.

Der kleinste Kopfdurchmesser D beträgt ca. 2 mm; der Konuswinkel 22 liegt zweckmäßig im Bereich von 50°.

Sofern erforderlich, kann auf der dem Prägestempel 20 abgewandten Seite des Blechstreifens 2 eine nicht näher dargestellte Matrize angeordnet sein, um die Prägekräfte abzustützen. Der Prägevorgang ist derart gesteuert, daß die äußere Kontur des Haltezapfens 5 leicht konisch verjüngt zuläuft. Dieser äußere Konuswinkel 9 ist sehr klein; er liegt im Bereich von 0,5-5°.

Der innere Hohlraum 16 des Haltezapfens 5 verläuft in Richtung auf sein geschlossenes Ende konisch verjüngt zu, wobei der Konuswinkel 19 etwa 25° beträgt. Der äußere Konuswinkel 9 ist insoweit deutlich kleiner vorgesehen als der innere Konuswinkel 17.

Die Wandstärke des Haltezapfens 5 ist kleiner als die Dicke d des als Träger 1 vorgesehenen Bleches.

Jeder Haltezapfen 5 steht auf der den Leuchtdioden 10 zugewandten Kontaktseite 17 des Trägers 1 vor; es kann zweckmäßig sein, den Träger 1 bzw. die Blechstreifen 2 und 3 auf beiden Seiten mit Haltezapfen 5 zur Bestückung von elektronischen Bauelementen auszubilden. Die Haltezapfen 5 stehen dabei etwa senkrecht zur Ebene des Trägers 1.

In den Anschlußfahnen 11 der LEDs 10 sind - wie insbesondere die Fig. 1 und 2 zeigen - Aufnahmeöffnungen 12 eingestanzt. Die Öffnungen 12 können vollständig oder auch nur zum Teil in der Anschlußfahne 11 ausgebildet sein. Die Leuchtdioden 10 werden mit ihren Anschlußfahnen 11 derart auf den Träger 1 aufgesetzt, daß der Haltezapfen 5 die Öffnung 12 in der Anschlußfahne 11 durchragt. Zweckmäßig sind die Abmessungen so vorgesehen, daß der Kopfdurchmesser K des freien Kopfendes 7 des Haltezapfens 5 geringfügig kleiner als der Durchmesser N der Nietöffnung ist, während der Fußdurchmesser F des Haltezapfens 5 geringfügig größer als der Durchmesser N der Öffnung 12 in der Anschlußfahne 11 ist. Dadurch ergibt sich beim Aufsetzen der Anschlußfahne 11 auf den Haltezapfen 5 ein Festklemmen, so daß die Leuchtdioden 10 ohne weitere Hilfsmittel auf dem Träger 1 vorfixiert sind.

Die Höhe H des Haltezapfens 5 ist größer als die Dicke a der Anschlußfahne 11 vorgesehen, so daß der Haltezapfen 5 die Anschlußfahne 11 durchragt. Das aus der Anschlußfahne 11 vorstehende Kopfende 7 des Haltezapfens 5 wird mittels eines Nietstempels 30 verformt, wie in Fig. 2 dargestellt. Der Nietstempel 30 kann einen kegelförmigen Nietkopf 31 aufweisen, welcher im gezeigten Ausführungsbeispiel einen Kegelwinkel 23 von etwa 130° aufweist. Die Verformung des Kopfendes des Haltezapfens ist auch zylindrisch durch axiales Stauchen und/oder Absetzen. Mittels des Nietstempels 30 wird das Kopfende 7 derart verquetscht, daß es den Rand 13 der Nietöffnung 12 übergreift, wodurch die Anschlußfahne unverlierbar fest mit dem Träger 1 verbunden ist. Der Nietstempel 30 fährt beim Verquetschen des Kopfendes 7 des Haltezapfens 5 in Pfeilrichtung 33 axial auf den Haltezapfen 5 zu, wobei aufgrund des kegligen Nietkopfes 31 eine seitliche Materialverlagerung bei gleichzeitiger axialer Stauchung des Haltezapfens 5 erzielt wird. Dies bewirkt einerseits das Übergreifen des Öffnungsrandes 13 durch das verquetschte Kopfende 7 und andererseits ein festes Aufdrücken der Anschlußfahne 11 auf die Kontaktseite 17 des elektrisch leitenden Trägers 1. Die Anschlußfahne 11 ist somit zwischen dem den Rand 13 übergreifenden Material 6 und dem Träger 1 spielfrei verklemmt. Das Verquetschen des Haltezapfens 5 gewährleistet dabei nicht nur eine formschlüssige mechanische Verankerung der Anschlußfahnen auf dem Träger 1, sondern auch eine gut elektrisch leitende Verbindung zwischen den Anschlußfahnen 11 und dem elektrisch leitenden Träger 1. Die mechanische Verbindung ist dabei derart stabil, daß der Träger 1 auch nach Entfernen der Verbindungsstege 4 eine hohe mechanische Stabilität aufweist und eine gut elektrisch leitende Verbindung auch unter härtesten Einsatzbedingungen auf Dauer sicherstellt.

Von besonderer Bedeutung ist die Tatsache, daß das elektrisch leitende Verbinden der LEDs 10 mit dem Träger 1 in einer einzigen Bearbeitungsstation erfolgen kann. In einer derartigen Station werden zunächst die Haltezapfen 5 aus dem elektrisch leitfähigen und ausreichend duktilen Material des Trägers 1 gezogen bzw. geprägt. Durch ein anderes Werkzeug wird die Lochung der Anschlußfahnen 11 der LEDs 10 durchgeführt. Diese vorher gelochten Anschlußfahnen 11 werden dann auf die Haltezapfen 5 aufgesetzt und - aufgrund der Geometrie der Haltezapfen - auf diesen festgeklemmt. Ohne weitere mechanische Hilfsmittel sind die LEDs 10 auf dem Träger 1 fixiert; die aus den Anschlußfahnen vorstehenden Kopfenden der Haltezapfen werden in einem folgenden Quetschvorgang mittels eines Nietstempels verformt werden, um den Rand der Öffnung 13 zu übergreifen und die Anschlußfahne 11 fest, formschlüssig und unverlierbar auf dem Träger 1 zu fixieren.

Als Trägermaterial ist zweckmäßig ein Blech gewählt, welches einerseits eine dem Einsatzfall angepaßte ausreichende elektrische Leitfähigkeit und andererseits eine ausreichende Duktilität zum Ziehen der Haltezapfen 5 aufweist. Dabei kann der Haltezapfen 5 bis auf eine Höhe H gezogen werden, die etwa der doppelten Dicke d des Trägermaterials entspricht. Die Anschlußfahne 11 hat zum Beispiel eine Dicke a, die geringer ist als die des Trägermaterials, so daß der Haltezapfen 5 über mindestens die Hälfte, bevorzugt mehr als die Hälfte seiner Höhe H aus der Öffnung 12 der Anschlußfahne 11 herausragt. Es steht somit ausreichend Material zur Verfügung, welches durch den Nietstempel verquetscht werden kann, um eine elektrisch leitende, mechanisch feste Verbindung der Anschlußfahne 11 mit dem Träger 1 zu erzielen.

## Patentansprüche

1. Träger zum mechanischen Halten und elektrischen Verbinden elektronischer Bauelemente, insbesondere von Leuchtdioden (10) oder dergleichen, bestehend aus einem elektrisch leitfähigen Material, mit dem die Anschlußfahnen (11) der elektronischen Bauelemente (10) elektrisch leitend verbunden sind,
dadurch gekennzeichnet, daß zumindest auf der Kontaktseite (17) des Trägers (1) noppenartige Haltezapfen (5) vorstehen, die als Hohlnieten aus dem Material des Trägers (1) ausgeprägt sind und eine Öffnung (12) in der Anschlußfahne (11) des Bauelementes (10) durchragen, wobei das mechanisch verformte Kopfende (7) des Haltezapfens (5) den Rand (13) der Öffnung (12) in der Anschlußfahne (11) übergreift.

2. Träger nach Anspruch 1,
dadurch gekennzeichnet, daß sich der Haltezapfen (5) zu seinem Kopfende (7) hin leicht konisch verjüngt.

3. Träger nach Anspruch 1 oder 2,
dadurch gekennzeichnet, daß der Kopfdurchmesser (K) des freien Kopfendes (7) des Haltezapfens (5) geringfügig kleiner ist als der Durchmesser (N) der Öffnung (12) in der Anschlußfahne (11) und der Fußdurchmesser (F) des Haltezapfens (5) geringfügig größer als der Durchmesser (N) der Öffnung (12) in der Anschlußfahne (11) ist.

4. Träger nach einem der Ansprüche 1 bis 3,
dadurch gekennzeichnet, daß der innere Hohlraum (16) des Haltezapfens (5) konisch verjüngt ausgebildet ist.

5. Träger nach Anspruch 3 und 4,
dadurch gekennzeichnet, daß der äußere Konuswinkel (9) geringer ist als der innere Konuswinkel (19).

6. Träger nach einem der Ansprüche 1 bis 5,
dadurch gekennzeichnet, daß die Wandstärke des Haltezapfens (5) kleiner ist als die Wandstärke (d) des Bleches (2, 3) des Trägers (1).

7. Träger nach einem der Ansprüche 1 bis 6,
dadurch gekennzeichnet, daß der Haltezapfen (5) eine Höhe (H) aufweist, die etwa der doppelten Dicke (d) des Bleches (2, 3) des Trägers (1) entspricht.

8. Träger nach einem der Ansprüche 1 bis 7,
dadurch gekennzeichnet, daß der nicht verquetschte Haltezapfen (5) über die Hälfte seiner Höhe (H), vorzugsweise etwas mehr als die Hälfte, aus der Öffnung (12) in der Anschlußfahne (11) vorsteht.

9. Träger nach einem der Ansprüche 1 bis 8,
dadurch gekennzeichnet, daß der Träger (1) ein elektrisch leitfähiges Blech (2, 3) aus duktilem Material ist.

10. Verfahren zum elektrisch leitenden Verbinden der Anschlußfahnen (11) von elektronischen Bauelementen (10), insbesondere von Leuchtdioden, mit einem elektrisch leitenden Träger (1) für die Bauelemente (10), wobei an vorgesehenen Befestigungspunkten (8) auf dem Träger (1) Haltezapfen (5) ausgeprägt werden, wonach die Bauelemente (10) mit in den Anschlußfahnen (11) vorgesehenen Öffnungen (12) auf die Haltezapfen (5) aufgesetzt werden und die aus den Öffnungen (12) hervorstehenden Kopfenden (7) der Haltezapfen (5) nach Art eines Nietkopfes verformt werden, um den Rand (13) der Öffnung (12) zu übergreifen.

11. Verfahren nach Anspruch 10,
dadurch gekennzeichnet, daß unmittelbar nach dem Ausprägen der Haltezapfen (5) die Anschlußfahne (11) aufgesetzt wird.

12. Verfahren nach Anspruch 10 oder 11,
dadurch gekennzeichnet, daß die Anschlußfahne (11) auf dem unverquetschten Haltezapfen (5) festgeklemmt wird.
